Europäisches Patentamt

European Patent Office

Office européen des brevets

(19)

(11)  **EP 1 653 504 A1**

(12)  # DEMANDE DE BREVET EUROPEEN

(43) Date de publication:
**03.05.2006 Bulletin 2006/18**

(51) Int Cl.:
***H01L 21/762*** (2006.01)

(21) Numéro de dépôt: **05109803.6**

(22) Date de dépôt: **20.10.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **29.10.2004 FR 0411579**

(71) Demandeur: **S.O.I.Tec Silicon on Insulator Technologies**
**38190 Bernin (FR)**

(72) Inventeurs:
• **Boussagol, Alice**
**38190, BRIGNOUD (FR)**
• **Faure, Bruce**
**38000, GRENOBLE (FR)**

(74) Mandataire: **Le Forestier, Eric**
**Cabinet Régimbeau**
**20, rue de Chazelles**
**75847 Paris cedex 17 (FR)**

(54)  **Structure composite à forte dissipation thermique**

(57)    Structure composite (40) pour des applications en optique, optoélectronique ou électronique, comprenant une plaque support (20), une couche en matériau choisi parmi les matériaux monocristallins, et une couche en matériau diélectrique (13), caractérisé en ce que les matériaux composant la plaque support (20), la couche en matériau monocristallin (11) et la couche diélectrique (13) sont choisis, et l'épaisseur de chaque couche est ajustée, de sorte que l'impédance thermique de la structure composite (40) soit inférieure ou égale à environ 1,3 fois l'impédance thermique d'une plaque de SiC massif monocristallin ayant les mêmes dimensions que la structure composite entre la température ambiante et 600°K.

L'invention concerne en outre un procédé de réalisation de cette structure composite (40).

FIG.2

EP 1 653 504 A1

## Description

L'invention concerne une structure composite pour des applications en optique, optoélectronique ou électronique, comprenant une plaque support et une structure en couche comprenant au moins une couche en matériau choisi parmi les matériaux monocristallins. En particulier, une telle structure composite est destinée soit à servir de substrat pour la formation d'une couche utile monocristalline, soit à inclure une telle couche utile monocristalline, cette couche utile incluant des dispositifs ou composants dont le fonctionnement entraîne une forte élévation thermique dans la couche utile.

Pour de telles couches utiles, on comprend bien que l'évacuation de la chaleur dégagée par les composants devient un problème critique lorsque les fréquences de fonctionnement de ces composants et/ou leur degré de miniaturisation augmentent.

On pourra par exemple citer le cas des applications CMOS pour lesquelles la miniaturisation des composants et l'amincissement des couches utiles entraînent de plus en plus de problèmes d'évacuation de la chaleur, notamment dans le cas où ces couches utiles sont plus ou moins séparées thermiquement du substrat support sur lequel elles sont formées. En particulier, des composants CMOS réalisés dans des structures SOI (abréviation anglo-saxonne de « Silicon-On-Insulator », signifiant « Silicium-Sur-Isolant »), SiGeOI (abréviation anglo-saxonne de « SiGe-On-Insulator », signifiant «Si-Ge-Sur-Isolant»), GeOI (abréviation anglo-saxonne de « Ge-On-Insulator », signifiant « Ge-Sur-Isolant ») ou SGOI (abréviation anglo-saxonne de « Si/SiGe-On-Insulator », signifiant « Si/SiGe-Sur-Isolant »), peuvent présenter des problèmes d'élévation thermique (entraînant des perturbations dans le comportement des composants) dus notamment au fait que la couche d'oxyde (constituant typiquement l'isolant de ces structures) forme une barrière thermique entre un substrat, par exemple en silicium, et la couche utile. De telles structures SOI, SiGeOI, SGOI, GeOI peuvent être par exemple réalisées par Smart-Cut®, telle que divulguée dans US 2004/0053477.

On pourra aussi par exemple citer le cas des composants fonctionnant à haute fréquence de puissance (typiquement supérieure à 900 MHz) qui peuvent entraîner des élévations thermiques aptes à les perturber, voire à les détériorer. Pour pallier cet inconvénient, les couches utiles sont habituellement réalisées en semiconducteur de nitrure ayant des propriétés de transport de charge (haute vitesse de saturation des porteurs sous haute tension, tension de claquage élevée, ...) améliorées par rapport à des matériaux comme l'AsGa. Ceci est en particulier vrai pour les composants de type transistor à haute mobilité électronique (encore appelé HEMT pour « High Electron Mobility Transistor »). Pour former de telles couches à base de semiconducteur de nitrure, on utilise alors des supports à la croissance en SiC massif monocristallin, en Si <111> massif ou en saphir ($Al_2O_3$) massif, qui ont des paramètres de maille sensiblement plus proches que ceux du silicium <100> massif monocristallin.

Cependant, le Si <111> et le saphir ont des impédances thermiques encore trop élevées pour certaines applications à haute fréquence de puissance qui requièrent une plus grande dissipation de la chaleur dégagée, et le SiC monocristallin massif, même s'il reste un matériau de référence en matière de dissipation de la chaleur, est économiquement trop coûteux.

Les documents US 6,328,796 et US 2003/0064735 divulguent des structures composites réalisées par collage de couches minces à des plaques support en matériaux polycristallins choisis suivant leurs propriétés de conductivité thermique, électrique et de dilatation thermique (tels que des substrats en SiC polycristallin), par l'intermédiaire d'une couche de collage en matériau diélectrique ayant pour fonction d'améliorer le collage entre la couche mince et la plaque support et pour favoriser l'apparition d'éventuels phénomènes de compliance.

Cependant, les matériaux, les dimensions des différentes couches et plaque support, les méthodes de réalisation de la structure, sont choisis de sorte à satisfaire des spécifications physiques telles que la conduction thermique, la conduction électrique, et la dilation thermique. Pour répondre à ces différentes spécifications, est donc arrêté un choix de structure imposant des solutions de compromis qui ne peuvent donner complète satisfaction. Les structures composites divulguées dans ces documents ne sont donc pas optimisées pour les applications à haute fréquence de puissance nécessitant une dissipation thermique importante.

Un premier objectif de l'invention est de proposer une structure composite ayant une bonne dissipation thermique.

Un deuxième objectif de l'invention est de proposer une telle structure composite réalisée de telle manière que son coût économique soit moins élevé que celui d'une structure en SiC massif monocristallin, et disponible en taille supérieure à 3 pouces.

Un troisième objectif de l'invention est d'améliorer le fonctionnement des composants HEMT ou CMOS miniaturisés à moindre coût.

Un quatrième objectif de l'invention est de réaliser une structure pour des applications HEMT ayant une bonne conductivité thermique et une caractéristique électrique semi-isolante (i.e. hautement résistive).

A cet effet, l'invention propose selon un premier aspect, une structure composite pour des applications en optique, optoélectronique ou électronique, comprenant une plaque support et une couche en matériau choisi parmi les matériaux monocristallins et une couche en matériau diélectrique, caractérisé en ce que les matériaux composant la plaque support, la couche en matériau monocristallin et la couche diélectrique sont choisis, et l'épaisseur de chaque couche est ajustée, de sorte que l'impédance thermique de la structure composite soit inférieure ou égale à environ 1,3 fois l'impédance thermique d'une plaque de SiC massif monocristallin ayant les mêmes dimensions que la structure composite entre la température ambiante et 600°K.

On rappelle ici que l'impédance thermique d'une structure $\Phi$ est calculée à partir des résistivités thermiques $R_i$ des différentes couches $i$ de la structure

$$\left( \Phi = 1/\sum_i R_i \right).$$ La résistivité thermique d'un matériau se définit par son élévation en °C, ou en °K, sur une surface d'1 mètre carré (qui est la surface de la couche ou substrat considéré) par puissance en Watt fournie. La résistivité thermique est aussi égale au rapport entre l'épaisseur de la couche (ou du substrat) considérée et la conductivité thermique du matériau utilisé.

D'autres caractéristiques de cette structure composite sont :

- la plaque support est en un matériau ayant une impédance thermique sensiblement plus faible que l'impédance thermique du silicium massif monocristallin ;
- la matériau de la plaque support a en outre une résistivité électrique supérieure à $10^4$ ohms.cm ;
- l a plaque support est en SiC massif polycristallin, en AIN massif polycristallin ou en céramique ;
- l'épaisseur de la couche en matériau diélectrique et l'épaisseur de la couche en matériau monocristallin sont choisies de sorte que l'impédance thermique de la structure composite soit inférieure ou égale à environ 1,3 fois l'impédance thermique qu'une plaque en SiC massif monocristallin ayant les mêmes dimensions que la structure composite entre la température ambiante et 600°K ;
- le matériau diélectrique est du $SiO_2$ et/ou du $Si_3N_4$ et/ou du $Si_xO_yN_z$;
- l'épaisseur de la couche en matériau diélectrique est choisie inférieure à environ 0,20 micromètre, et éventuellement supérieure à environ 0,02 micromètre, l'épaisseur de la couche en matériau monocristallin étant alors choisie en fonction de cette épaisseur de sorte que la structure composite soit inférieure ou égale à environ 1,3 fois l'impédance thermique qu'une plaque en SiC massif monocristallin ayant les mêmes dimensions que la structure composite entre la température ambiante et 600°K ;
- le matériau de la couche en matériau monocristallin est choisi parmi les matériaux semiconducteurs de sorte à pouvoir y former des composants électroniques ;
- le matériau monocristallin est du Si, du SiGe, ou du Ge ;
- la couche en matériau semiconducteur comprend au moins un composant électronique de type CMOS ;
- le matériau monocristallin de la couche en matériau monocristallin est choisi pour réussir une croissance d'un semiconducteur de nitrure monocristallin, la structure composite servant ainsi de substrat à la croissance de ce semiconducteur de nitrure, et pour avoir une résistivité électrique supérieure à environ $10^4$ ohms.cm ;
- ledit matériau monocristallin est du SiC, du Si<111>, ou du GaN ;
- l'épaisseur de la couche en matériau monocristallin est supérieure à une épaisseur seuil d'environ 0,06 micromètre, et éventuellement inférieure à environ 1 micromètre ;
- la plaque support est en SiC polycristallin, la couche en matériau monocristallin est en Si<111 > et a une épaisseur choisie entre 0,2 et 1 micromètre ; et la couche en matériau diélectrique est en $SiO_2$ et a une épaisseur d'environ 0,2 micromètre ;
- la plaque support est en SiC polycristallin ; la couche en matériau monocristallin est en Si<111 > et a une épaisseur choisie entre 0,06 et 1 micromètre ; et la couche en matériau diélectrique est en $SiO_2$ et a une épaisseur d'environ 0,05 micromètre.

Selon un deuxième aspect, le procédé selon l'invention propose une structure hybride, caractérisé en ce qu'il comprend ladite structure composite et une structure supérieure monocristalline sur la couche en matériau monocristallin, le(s) matériau(x) constituant la structure supérieure étant adapté(s) pour améliorer la qualité de la couche du semiconducteur de nitrure à former sur la structure hybride par rapport au cas où la couche de semiconducteur de nitrure aurait été formée directement sur la couche en matériau monocristallin.

D'autres caractéristiques de cette structure hybride sont :

- la couche en matériau monocristallin est en SiC, en Si <111>, ou en GaN, la structure supérieure comprend une couche en un matériau choisi parmi les alliages suivants : $Al_xIn_yGa_{(1-x-y)}N$, $In_yGa_{(1-y)}N$, $Al_xGa_{(1-x)}N$ avec $0 \leq x \leq 1$ et $0 \leq y \leq 1$ ;
- au moins un des éléments de l'alliage choisi parmi les alliages suivants : $Al_xIn_yGa_{(1-x-y)}N$, $In_yGa_{(1-y)}N$, $Al_xGa_{(1-x)}N$ avec $0 \leq x \leq 1$ et $0 \leq y \leq 1$, a sa concentration variant graduellement en épaisseur.

Selon un troisième aspect, l'invention propose une structure pour application dans les HEMTs comprenant ladite structure composite ou ladite structure hybride, et une couche en GaN monocristallin sus-épitaxiée.

Selon un quatrième aspect, l'invention propose un procédé de réalisation d'une structure composite, à partir d'une plaque donneuse comportant un matériau monocristallin, caractérisé en ce qu'il comprend les étapes suivantes :

(a) collage d'une plaque support à la plaque donneuse;
(b) réduction de la plaque donneuse de sorte à ne laisser sur la plaque support, qu'une structure reportée incluant ledit matériau monocristallin sous forme de couche et dont la nature et l'épaisseur soient telles que la structure composite ainsi formée ait une impédance thermique inférieure ou égale à environ 1,3 fois l'impédance thermique d'une plaque de SiC massif monocristallin ayant les mêmes dimensions que la structure composite entre la température ambiante et 600°K.

D'autres caractéristiques du procédé de réalisation d'une structure composite sont :

- ledit procédé comprend en outre un choix d'un matériau massif pour la plaque support qui a une impédance thermique sensiblement plus faible que l'impédance thermique du silicium massif monocristallin entre la température ambiante et 600°K ;
- la plaque support est choisie en SiC massif polycristallin, en AlN massif polycristallin, ou en céramique ;
- l'étape (a) comprend la formation d'une couche de collage en matériau diélectrique entre la plaque support et la plaque donneuse, de sorte que l'épaisseur de cette couche de collage soit inférieure à une épaisseur plafond au-delà de laquelle l'impédance thermique de la structure composite n'est pas inférieure ou égale à environ 1,3 fois l'impédance thermique d'une plaque de SiC massif monocristallin ayant les mêmes dimensions que la structure composite entre la température ambiante et 600°K ;
- ledit procédé comprend en outre, avant l'étape (a), une étape d'implantation d'espèces atomiques sous la surface de collage de la plaque donneuse à une profondeur déterminée pour y former une zone de fragilisation, et l'étape (b) comprend un apport d'énergie de sorte à détacher la structure reportée de la plaque donneuse au niveau de la zone de fragilisation, la profondeur de l'implantation étant déterminée pour que la zone de fragilisation et la surface de collage définissent entre elles la structure reportée ;
- l'étape (b) est mise en oeuvre par des moyens mécaniques et/ou chimiques aptes à amincir l'épaisseur de la plaque donneuse ;
- la plaque donneuse est en matériau massif monocristallin, et l'étape (b) est mise en oeuvre de sorte à ne conserver de la plaque donneuse qu'une couche dont l'épaisseur est choisie pour que la structure composite formée ait une impédance thermique inférieure ou égale à environ 1,3 fois l'impédance thermique d'une plaque de SiC massif monocristallin ayant les mêmes dimensions que la structure composite entre la température ambiante et 600°K ;
- la plaque donneuse est en Si massif monocristallin ou en Ge massif monocristallin ;
- la plaque donneuse est en SiC massif monocristallin ;
- la plaque donneuse comprend initialement ladite couche en matériau monocristallin et un substrat de croissance adapté, et le procédé comprend en outre, avant l'étape (a), une étape de formation de la plaque donneuse incluant la croissance cristalline de la couche en matériau monocristallin sur le substrat de croissance adapté ;
- le substrat de croissance comprend du Si massif ou du Ge massif ainsi qu'une couche tampon en SiGe, et la couche en matériau monocristallin est en Si<100> ou en SiGe ;
- le substrat de croissance comprend du saphir ($Al_2O_3$) massif, du SiC monocristallin massif, du ZnO massif, ou du Si<111> massif, et la couche en matériau monocristallin est en SiC, en Si<111 >, en GaN, en AlN, en InN, en $Al_xIn_yGa_{(1-x-y)}$, en $In_yGa_{(1-y)}N$, ou en $Al_xGa_{1-x}N$ avec $0 \le x \le 1$ et $0 \le y \le 1$ ;

Selon un cinquième aspect, l'invention propose un procédé de réalisation d'une structure hybride comprenant la réalisation d'une structure composite conformément audit procédé de réalisation d'une structure composite, caractérisé en ce qu'il comprend en outre la croissance cristalline d'une structure supérieure monocristalline sur la couche en matériau monocristallin de sorte que la structure supérieure ait une configuration et qu'elle soit constituée par des matériaux permettant d'améliorer la qualité d'une couche en semiconducteur de nitrure à former par rapport au cas où cette formation de semiconducteur de nitrure serait faite directement sur la couche en matériau monocristallin.
D'autres caractéristiques du procédé de réalisation d'une structure composite sont :

- la structure supérieure comprend une couche choisie parmi les alliages suivants : $Al_xIn_yGa_{(1-x-y)}N$, $In_yGa_{(1-y)}N$, $Al_xGa_{(1-x)}N$ avec $0 \le x \le 1$ et $0 \le y \le 1$ ;
- la structure supérieure comprend une couche choisie parmi les alliages suivants : AlxInyGa(1-x-y)N, InyGa(1-y)N, AlxGa(1-x)N avec $0 \le x \le 1$ et $0 \le y \le 1$, au moins un des éléments de l'alliage choisi ayant sa concentration variant graduellement dans l'épaisseur.

D'autres caractéristiques, buts et avantages de l'invention apparaîtront mieux à la lecture de la description détaillée suivante de l'invention, donnée à titre d'exemple non limitatif et faite en référence aux dessins annexés pour lesquels :

La figure 1 représente schématiquement une première structure composite selon l'invention.
La figure 2 représente schématiquement une deuxième structure composite selon l'invention.
La figure 3 représente schématiquement une première structure hybride selon l'invention.
La figure 4 représente schématiquement une deuxième structure hybride selon l'invention.

Les figures 5a à 5e représentent des étapes d'un mode de réalisation d'une structure composite selon l'invention.

Les figures 6 et 7 représentent les résultats de simulations de comportements thermiques réalisées sur différents supports GaN, dont une structure composite selon l'invention.

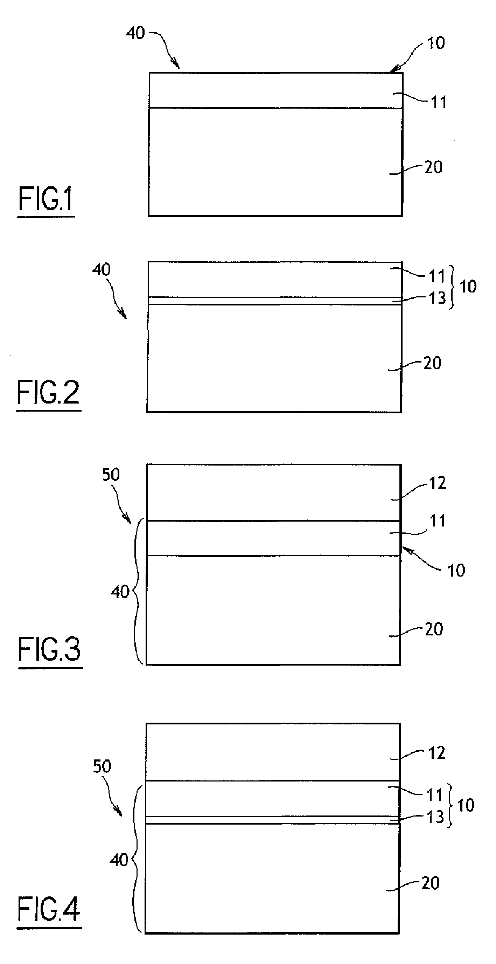

En référence aux figures 1, 2, 3 et 4 sont représentés respectivement quatre exemples de structures composites et hybrides selon l'invention, chacune étant destinée à des applications en optique, optoélectronique ou électronique. Chaque structure composite 40 comprend une plaque support 20 et une couche monocristalline 11 en matériau choisi parmi les matériaux monocristallins.

Le (ou les) matériau(x) composant la plaque support 20 est choisi pour, principalement, ses propriétés de forte conductivité thermique (forte conductivité thermique s'entend comme une conductivité sensiblement plus grande que la conductivité du silicium massif monocristallin <100>). Le choix du matériau composant la plaque support 20 peut aussi se porter sur un matériau ayant une conductivité thermique telle que son impédance thermique est sensiblement inférieure ou égale à une impédance thermique 30 % plus élevée que celle d'une plaque de SiC massif monocristallin ayant les mêmes dimensions que la structure composite entre la température ambiante et 600°K. Le SiC massif monocristallin est ici une référence dans le domaine de la conductivité thermique des matériaux cristallins, sa conductivité thermique se situant typiquement autour de 440 W/m.°K à température ambiante (i.e. à 300°K) à $\pm$ 20 % près selon la qualité et la structure du matériau. On pourra aussi choisir comme conductivité thermique de référence celle du 6H-SiC (environ 490 W/m.°K), celle du 4H-SiC (environ 370 W/m.°K environ), ou celle du 3C-SiC (environ 360 W/m.°K environ).

Le choix du matériau composant la plaque support 20 est en outre motivé par des contraintes économiques de coût de matériau qui doivent être sensiblement plus faibles que celles associées au SiC massif monocristallin, et de disponibilité en taille. Sur ce dernier point, on pourra rechercher une plaque support 20 disponible à plus de 3 pouces.

On pourra ainsi choisir notamment une plaque support 20 en SiC polycristallin, en AIN polycristallin ou en céramique adapté thermiquement.

En outre, il sera avantageux, notamment dans le cas d'applications HEMT, de choisir une plaque support 20 à forte résistivité, c'est-à-dire supérieure à $10^4$ohms.cm.

Sur la plaque support 20, se trouve une couche monocristalline 11 dont le (ou les) matériau(x) la composant est choisi et dont l'épaisseur est ajustée, de sorte que, ensemble avec la plaque support 20, l'impédance thermique de l'ensemble de la structure composite 40 soit inférieure ou égale à environ 1,3 fois l'impédance thermique d'une plaque de SiC monocristallin massif ayant les mêmes dimensions que la structure composite 40 entre la température ambiante et 600°K (températures de fonctionnement typiques des composants à haute fréquence de puissance). On pourra en particulier choisir, pour la couche monocristalline 11, une épaisseur supérieure à une épaisseur seuil en deçà de laquelle la structure composite ne serait pas inférieure ou égale à environ 1,3 fois l'impédance thermique d'une plaque de SiC monocristallin massif ayant les mêmes dimensions que la structure composite 40 entre la température ambiante et 600°K. En particulier, cette épaisseur seuil peut se situer autour de 0,06 $\mu$m pour des matériaux tels que Si, SiGe, Ge, SiC, Si<111> ou GaN. On pourra par exemple choisir une couche monocristalline 11 ayant une épaisseur se situant entre l'épaisseur seuil et 1 $\mu$m.

Selon une première configuration de la structure composite 40 selon l'invention, la structure monocristalline 11 est destinée à recevoir des composants électroniques, optiques ou optoélectroniques, tels que des transistors de type CMOS. Dans ce cas, les matériaux choisis pour la couche monocristalline 11 peuvent être en Si, SiGe, Ge,. Dans ce cas, les composants qui seront formés dans la couche monocristalline 11 ou qui sont déjà formés dans la couche monocristalline 11, bénéficieront de la structure particulière de la structure composite 40 pour évacuer la chaleur importante qu'ils dégageront lors de leur fonctionnement, diminuant ainsi les risques de perturbation voire de détérioration.

Selon une deuxième configuration, la structure composite 40 est un substrat pour la formation d'une couche utile constituée d'un matériau apte à inclure des composants fonctionnant à haute fréquence de puissance, tel qu'un semi-conducteur de nitrure (par exemple du GaN). Les matériaux choisis pour constituer la couche monocristalline 11 peuvent alors être par exemple du SiC, du Si<111>, ou du GaN, AIN, ou autres semiconducteurs de nitrure. Ces matériaux sont en outre choisis avec une forte résistivité électrique (supérieure à $10^4$ohms.cm). La structure composite 40 selon l'invention permet alors, lorsque la couche utile aura été formée, d'évacuer de façon importante la chaleur dégagée par les composants, et notamment dans le cas où ces composants fonctionnent à haute fréquence de puissance, ce qui est par exemple le cas de transistors HEMT.

Préférentiellement, et en référence aux figures 2 et 4, la structure en couche 10 comprend en outre une couche isolante 13 réalisée en matériau diélectrique, tel que du $SiO_2$ et/ou du $Si_3N_4$ et/ou du $Si_xO_yN_z$, et disposée à l'interface avec la plaque support 20. Cette couche isolante 13 peut être particulièrement utile lors de la réalisation de cette structure composite 40 (comme décrit plus loin) puisqu'elle est choisi pour avoir des propriétés de collage intéressantes lorsqu'on va réaliser la structure composite 40 selon une technique de collage. En outre, le matériau composant cette couche isolante 13 peut être choisi pour présenter une résistivité électrique importante, ce qui peut être un avantage important lors d'un fonctionnement de composants de puissance HEMT. L'épaisseur de la couche isolante 13 est choisie inférieure à une épaisseur plafond au-delà de laquelle l'impédance thermique de la structure composite n'est pas inférieure ou égale à environ 1,3 fois l'impédance thermique d'une plaque de SiC monocristallin massif ayant les mêmes dimensions que la structure composite 40 entre la température ambiante et 600°K. Le choix des épaisseurs pour la couche isolante 13 et pour la couche monocristalline 11 peut se faire l'un avant l'autre, ou selon une méthode par approximations successives.

En particulier, l'épaisseur de la couche monocristalline 11 peut être adaptée pour que sa surface libre soit à une certaine distance de la couche isolante 13. En effet, cette couche isolante 13, même si on choisit de la réaliser sur une faible épaisseur, reste une barrière thermique qui peut poser des problèmes de dissipation thermique lors du fonctionnement de composants inclus dans une couche utile épitaxiée sur la couche monocristalline 11. Le fait, donc, d'éloigner la surface d'épitaxie (i.e. la surface de la couche monocristalline 11) de la couche isolante 13 enterrée améliore ainsi la dissipation de la chaleur.

En référence à la figure 1, une première structure composite 40 selon l'invention y est représentée, dans laquelle la structure en couche 10 n'est ici constituée que de la couche monocristalline 11 directement en contact avec la plaque support 20. Dans cette configuration, les principaux paramètres qu'il y a lieu d'ajuster sont les matériaux choisis pour constituer respectivement la plaque support 20 et la couche monocristalline 11, ainsi que l'épaisseur de la couche monocristalline 11 de sorte que cette structure composite 40 ait une impédance thermique inférieure ou égale à 1,3 fois l'impédance thermique d'une plaque de SiC monocristallin massif ayant les mêmes dimensions que la structure composite 40 entre la température ambiante et 600°K.

On peut ainsi choisir une couche monocristalline 11 ayant une épaisseur comprise entre 0,06 et 1 $\mu$m.

En référence à la figure 2, est représentée une deuxième structure composite 40 selon l'invention, dans laquelle la structure en couche 10 est ici constituée de la couche monocristalline 11 et d'une couche en matériau diélectrique 13 se situant entre la plaque support 20 et la couche monocristalline 11. Cette dernière couche isolante 13 a une épaisseur qui est choisie inférieure à une épaisseur plafond au-delà de laquelle l'impédance thermique de la structure composite ne serait plus inférieure ou égale à environ 1,3 fois l'impédance thermique d'une plaque de SiC monocristallin massif ayant les mêmes dimensions que la structure composite 40 entre la température ambiante et 600°K, en considérant bien sûr que les matériaux choisis pour la plaque support 20 et la couche monocristalline 11 soient déjà établis, ainsi que l'épaisseur de la couche monocristalline 11.

Ainsi, la couche isolante 13 peut avoir une épaisseur comprise entre 0,02 $\mu$m et 0,2 $\mu$m.

On pourra par exemple choisir comme matériau la constituant du $SiO_2$ et/ou du $Si_3N_4$ et/ou du $Si_xO_yN_z$.

Sachant cela, on pourra aussi choisir une couche monocristalline 11 ayant une épaisseur comprise entre 0,06 et 1 $\mu$m.

Par exemple, on pourra avoir la structure composite 40 suivante :

- la plaque support 20 est en SiC polycristallin ;
- la couche en matériau monocristallin 11 est en Si<111> et a une épaisseur choisie entre 0,2 et 1,0 micromètre ; et
- la couche en matériau diélectrique (13) est en $SiO_2$ et a une épaisseur d'environ 0,20 micromètre.

Par exemple, on pourra avoir la structure composite 40 suivante :

- la plaque support 20 est en SiC polycristallin;
- la couche en matériau monocristallin 11 est en Si<111 > et a une épaisseur choisie entre 0,06 et 1,00 micromètre ; et
- la couche en matériau diélectrique 13 est en $SiO_2$ et a une épaisseur d'environ 0,05 micromètre.

En référence aux figures 3 et 4, une structure hybride 50 est réalisée en ajoutant une structure supérieure 12 à la structure en couche 10, sur la couche monocristalline 11, le ou les matériau(x) constituant cette structure supérieure 12 étant adaptés pour améliorer la qualité d'une couche en matériau cristallin à former sur la structure hybride 50. Ces structures hybrides 50 sont donc particulièrement bien agencées pour servir de substrat à la croissance cristalline d'une couche utile en matériau adapté aux hautes fréquences de puissance, tel qu'un semiconducteur de nitrure comme le GaN. Dans ce dernier cas, la nature et la configuration de la structure supérieure 12 sont choisies pour améliorer la qualité de la couche utile à former par rapport au cas où cette couche utile aurait été formée directement sur la couche monocristalline 11, en adaptant un paramètre de maille à partir de la structure composite 40 de sorte à se rapprocher d'avantage de celui de la couche utile à former (évitant ainsi notamment la création de dislocations ayant une densité trop importante, et engendrées dans une couche utile qui seraient contrainte de subir des désaccords de maille trop importants avec son support de croissance). On pourra par exemple choisir une structure supérieure 12 semblable ou équivalente aux structures tampon divulguées dans les documents US 2003/136333 et US 6,617,060, à savoir une structure supérieure 12 comprenant au moins une couche en $Al_xIn_yGa_{(1-x-y)}N$, en $In_xGa_{1-y}N$, ou en $Al_xGa_{1-x}N$ (avec x compris entre 0 et 1 et y compris entre 0 et 1), avec une couche ayant une composition ne variant pas dans son épaisseur et/ou une couche ayant une composition variant graduellement dans l'épaisseur selon les configurations les plus avantageuses d'un point de vue technique et économique.. Cette structure supérieure 12, réalisée dans le but de former ultérieurement une couche utile de qualité, permet de surcroît d'éloigner cette couche utile de l'interface avec la plaque support 20, ce qui peut présenter un avantage dans le cas (en référence à la figure 4) où une couche isolante 13 est interfacée avec la plaque support 20 (cette couche isolante 13 pouvant en effet ralentir l'évacuation de la chaleur si elle a une épaisseur supérieure à une épaisseur seuil).

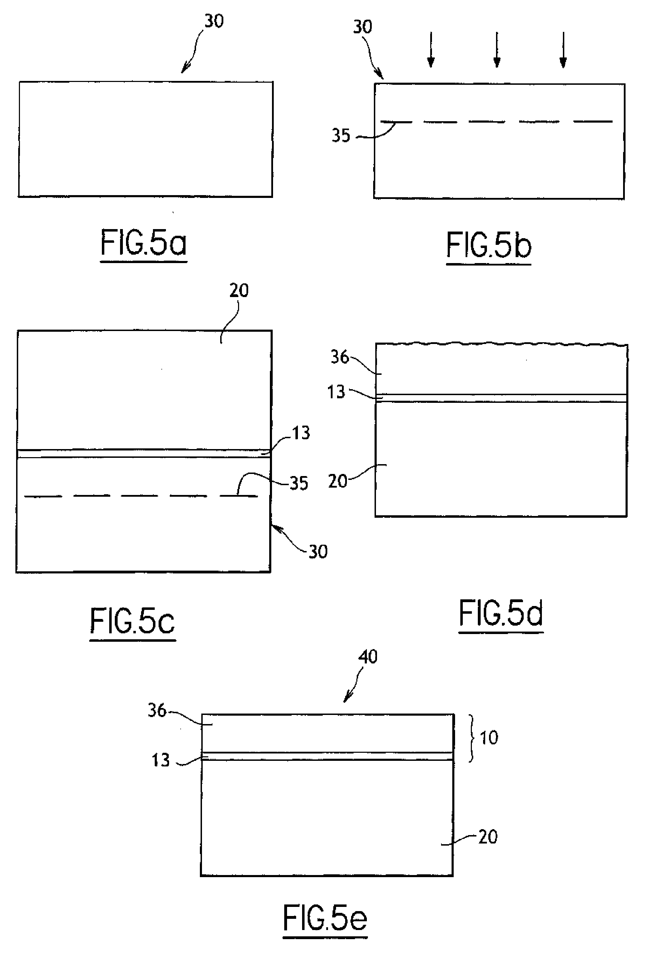

En référence aux figures 5a à 5e, différentes étapes d'un procédé de réalisation d'une structure composite 40 selon l'invention y sont représentées.

En référence à la figure 5a, une plaque donneuse 30 y est représentée, cette plaque donneuse 30 comportant un matériau monocristallin.

La plaque donneuse 30 peut, selon une première configuration, être constituée d'un matériau massif monocristallin.

Dans le cas où on souhaite réaliser une structure composite 40 pour une application de type CMOS, on pourra ainsi choisir une plaque donneuse 30 en Si<100> ou en Ge massif monocristallin.

Dans le cas où on souhaite réaliser une structure composite 40 servant de substrat à la croissance cristalline d'une prochaine couche en semi-conducteur de nitrure, on peut alors choisir un matériau massif en SiC monocristallin ou en Si<111> monocristallin.

Selon une deuxième configuration, la plaque donneuse 30 comprend initialement un substrat de croissance adapté à la croissance d'une couche en matériau monocristallin à transférer. Ce substrat de croissance comprend typiquement un support en matériau massif monocristallin.

On pourra ainsi avoir un substrat de croissance en saphir ($Al_2O_3$), en SiC, en ZnO massif ou en Si <111> massif monocristallin, et former par épitaxie une couche en matériau monocristallin SiC, Si <111 >, GaN, en AlN, en InN, en $Al_xIn_yGa_{(1-x-y)}$, en $In_yGa_{(1-y)}N$, ou en $Al_xGa_{1-x}N$ avec $0 \leq x \leq 1$ et $0 \leq y \leq 1$.

En outre, ce substrat de croissance peut comprendre une structure intermédiaire entre le support et la couche en matériau monocristallin à transférer, cette structure intermédiaire jouant la fonction de structure tampon, et étant éventuellement agencée de sorte à compenser des différences de dilatation thermique et/ou des différences de paramètres de maille et/ou à confiner des défauts. Ainsi par exemple, on pourra réaliser une couche monocristalline en Si <100> ou en SiGe relaxé, en la formant par croissance cristalline sur une couche tampon en SiGe, la composition de cette dernière évoluant graduellement dans son épaisseur à partir d'un support en Si<100> ou en Ge massif monocristallin.

En référence à la figure 5b, la plaque donneuse 20 est alors implantée par des espèces atomiques selon des dosages et des conditions d'énergie déterminés de sorte à former une zone de fragilisation 35 à une profondeur déterminée dans la plaque donneuse 30 avec une fragilisation mécanique déterminée. On pourra par exemple implanter des espèces atomiques comme des ions hydrogène entre $5.10^{16}$ et $8.10^{16}$ atomes par centimètre carré, implantés à une énergie comprise entre 10 et 200 keV.

La profondeur de la zone de fragilisation 35 est choisie de sorte à définir une épaisseur de matériau (comprise entre la zone de fragilisation 35 et la surface de la plaque donneuse 30 destinée à être collée à une plaque support 40 selon l'étape représentée sur la figure 5c) qui comprend au moins une partie de la structure en couche (non représentée) à reporter sur la plaque support 20. En particulier, cette implantation est mise en oeuvre de sorte que la structure en couche ainsi délimitée inclut un matériau monocristallin sous forme de couche et dont la nature et l'épaisseur de chaque couche la composant soient telles que la structure composite 40 à former (comprenant cette structure en couche une fois reportée et la plaque support 20 à coller) ait une impédance thermique inférieure ou égale à 1,3 fois celle du SiC massif monocristallin entre la température ambiante et 600°K.

Optionnellement, avant ou après cette implantation, une couche isolante 13 est formée sur la surface d'implantation. Cette couche isolante 13 peut par exemple être un oxyde ($SiO_2$) et/ou un nitrure ($Si_3N_4$ et/ou $Si_xO_yN_z$) avec une épaisseur telle que la structure composite 40 à former (voir figure 5e) ait une impédance thermique inférieure ou égale à environ 1,3 fois celle du SiC monocristallin massif entre la température ambiante et 600°K. On pourra par exemple former une couche en $SiO_2$ et/ou en $Si_3N_4$ et/ou en $Si_xO_yN_z$ avec une épaisseur allant de 0,02 $\mu$m à 0,2 $\mu$m.

La surface de collage (i.e. la surface ayant subie l'implantation) de la plaque donneuse 30 est alors optionnellement préparée au collage. Elle peut ainsi être nettoyée pour éliminer les contaminants (éléments métalliques, particulaires, hydrocarbures) et pour améliorer l'hydrophilie de la surface, polie mécano-chimiquement, activée par plasma,.... Optionnellement, dans le cas où on a formé une couche isolante 13 sur la surface d'implantation, la couche isolante peut être complètement enlevée lors de cette étape de nettoyage.

En référence à la figure 5c, une plaque support 20 est mise en contact avec la plaque donneuse 30 au niveau de la surface implantée.

Préférentiellement, une couche isolante a été antérieurement formée sur la surface de la plaque support 20 destinée à être collée. Dans tous les cas, l'épaisseur de la couche isolante 13 comprise entre la plaque support 20 et la plaque donneuse 30 est choisie de sorte à ne pas former une barrière thermique trop importante à l'évacuation de chaleur, c'est-à-dire que l'épaisseur de celle-ci est choisie de sorte que l'impédance thermique de la structure composite 40 à former (voir figure 5e) soit inférieure ou égale à environ 1,3 fois l'impédance thermique d'une plaque de SiC monocristallin massif ayant les mêmes dimensions que la structure composite 40 entre la température ambiante et 600°K.

Antérieurement à la mise en contact entre la plaque support 20 et la plaque donneuse 30, la surface de collage de la plaque support 20 a pu être préparée au collage en mettant en oeuvre par exemple des traitements de nettoyage pour améliorer son hydrophilie et/ou pour enlever des contaminants.

Optionnellement, d'autres préparations des deux surfaces à coller peuvent être mises en oeuvre telles qu'une CMP (pour « Chemico-Mechanical Planarization », signifiant « Planarisation Mécano-Chimique ») ou une activation plasma afin d'améliorer l'énergie de collage.

La mise en contact de la plaque donneuse 30 et de la plaque support 20 ainsi préparées peut éventuellement être faite à température ambiante.

Une fois les deux substrats collés, on peut renforcer le collage par un apport d'énergie thermique, comme par exemple un recuit à plus de 200°C pendant 2h00.En référence à la figure 5d, une énergie est apportée pour que les liaisons fragiles se situant au niveau de la zone de fragilisation 35 se rompent et qu'une structure reportée 36 en soit détachée, cette structure reportée 36 restant alors collée à la plaque support 20.

Cette structure reportée 36 comprend au moins en partie la structure en couche 10 à former sur la plaque support 40. L'énergie fournie peut être de type thermique et/ou mécanique, cette technique de report de couche étant par ailleurs bien connue de l'homme du métier sous le terme de Smart-Cut®, et est en particulier décrite dans « Silicon-On-Insulator Technology: Material to VLSI, 2nd Edition » de J-P Colinge (Kluwer Academic Publishers, p. 50 et 51).

Selon une variante, on peut réduire la plaque donneuse 30 à partir de la structure représentée sur la figure 5c par une autre technique que Smart-Cut®, les étapes précédant le collage et le collage en lui-même étant par ailleurs sensiblement identiques à celles présentées ci-dessus à l'exception de l'implantation (représentée sur la figure 5b). Cette autre technique de réduction de la plaque donneuse 30 utilise un amincissement mécanique (polissage, rodage, etc.) et/ou gravure chimique sèche en face arrière jusqu'à une épaisseur déterminée, qui peut être de quelques dizaines de microns. On peut ensuite utiliser différentes étapes de polissage mécano-chimique pour amincir la plaque donneuse 30 pour n'en laisser qu'une structure reportée 36 telle que représentée sur la figure 5d. Quelle qu'ait été la technique de réduction de la plaque donneuse 30 utilisée, une étape de finition de la surface de la structure reportée 36 est mise en oeuvre dans le but d'enlever les rugosités et les contaminants qui peuvent exister en surface.

Eventuellement, cette surface de détachement peut être préparée pour devenir une surface « epiready » (i.e. prête pour recevoir des éléments à épitaxier) en mettant en oeuvre par exemple une CMP et/ou une gravure chimique humide ou sèche (par plasma RIE par exemple).

On pourra aussi mettre en oeuvre des techniques permettant de retirer de la matière de façon sélective, telles qu'une gravure chimique sélective. A cet effet, on pourra alors prévoir dans la structure reportée 36, une couche d'arrêt à cet enlèvement de matière sélectif. Optionnellement, cette couche d'arrêt pourra ensuite être retirée afin d'obtenir au final une structure en couche 10 ayant une bonne qualité de surface avec peu de rugosités (voir figure 5e).

En référence à la figure 5e, on obtient au final une structure composite 40 selon l'invention comprenant une structure en couche 10 comprenant la structure reportée 36 et éventuellement la couche isolante 13, conformément à la structure composite 40 représentée sur la figure 1 ou 2.

Eventuellement, et postérieurement à ce transfert de la structure reportée 36 de la plaque donneuse 30 sur la plaque support 20, une croissance cristalline d'une structure supérieure 12 monocristalline sur la structure en couche 10 peut être mise en oeuvre de sorte à obtenir une des structures hybrides 50 représentées sur les figures 3 et 4.

Exemple 1 :

La Demanderesse a effectué des études comparatives pour des structures composites selon l'invention comprenant une plaque support 20 en SiC polycristallin, et une structure en couche 10 constituée d'une couche monocristalline 11 en silicium <111> et d'une couche isolante 13 en SiO$_2$. La résistivité de la plaque support 20 en SiC polycristallin était ici supérieure à 10$^5$ Ohm.cm. Ces structures composites 30 ont été réalisées par Smart-Cut® (dont les principales étapes ont été illustrées en référence aux figures 5a à 5e).

L'étude comparative faite par la Demanderesse a consisté à simuler le comportement thermique d'une telle structure composite 40 lorsque celle-ci supporte une couche de GaN incluant des composants HEMT en fonctionnement, en comparaison à d'autres types de supports de la même couche de GaN.

Un but de cette étude est de connaître l'influence des différents paramètres, tels que l'épaisseur de la couche isolante 13, l'épaisseur de la couche monocristalline 11, la nature de la plaque support 20, et la puissance dissipée par les composants HEMT sur la température dans la couche de GaN.

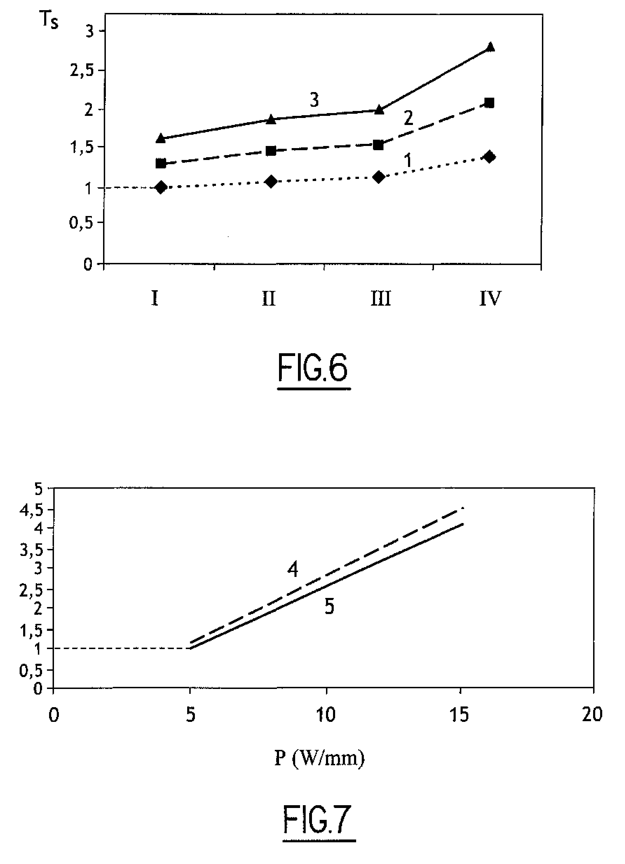

Les résultats sont présentés sur les figures 6 et 7.

En référence à la figure 6, est représenté un graphe donnant la température de surface Ts estimée (normalisée ici) au niveau du composant (i.e. sous la grille de celui-ci), en fonction du support choisi pour la couche de GaN. Ainsi :

- le support I est en SiC massif monocristallin ;
- le support II est en SiC polycristallin massif ;
- le support III est en Si<111>/SiO$_2$/SiC polycristallin massif ;
- le support IV est un support en Si<100> massif monocristallin.

Tous ces supports (I, II, III, IV) avaient les mêmes dimensions.

La courbe 1 (en traits pointés) représente le cas où la puissance appliquée est de 5 W/mm, la courbe 2 (en pointillés) celle du cas où la puissance appliquée est de 10 W/mm, et la courbe 3 (en trait plein) celle représentant le cas d'une puissance appliquée de 15 W/mm, qui sont des puissances typiquement dissipées par un composant de puissance.

La structure composite 40 selon l'invention (représentée sur ce graphe par la configuration III) comprend ici une structure en couche 10 constituée d'une couche monocristalline en Si<111> ayant une épaisseur de 2 $\mu$m et d'une couche isolante 13 en $SiO_2$ ayant une épaisseur de 1 $\mu$m.

Les résultats de cette simulation montrent qu'une structure composite 40 selon l'invention présente une dissipation de la chaleur bien plus grande (de l'ordre de 20 à 30 %) que dans le cas d'un support IV en silicium massif monocristallin, et seulement de l'ordre de 10 à 20 % moins importante que dans le cas d'un support I en SiC massif monocristallin, et encore moins en comparant avec un support II en SiC massif polycristallin (selon les puissances appliquées à la couche utile de GaN). L'élévation en température au niveau d'un composant dans la couche de GaN de la structure composite simulée est donc sensiblement proche de celle obtenue sur un substrat en SiC massif monocristallin. La Demanderesse en a déduit que ces résultats impliquaient une structure composite ayant une impédance thermique inférieure ou égale à 1,3 fois l'impédance thermique d'une plaque de SiC monocristallin massif ayant les mêmes dimensions que la structure composite 40 entre la température ambiante et 600°K.

Même si cette impédance thermique semble un peu plus élevée que celle d'un support équivalent en SiC monocristallin massif ou même qu'en SiC polycristallin massif, elle reste néanmoins satisfaisante lors d'un fonctionnement de transistor HEMT dans des couches de GaN à des fréquences de puissance élevées.

De plus, cette structure composite 40 permet l'épitaxie de couches de GaN de qualité, contrairement à un support ll en SiC polycristallin.

De plus, cette structure composite 40 est économiquement bien plus avantageuse qu'un support I en SiC monocristallin.

En référence à la figure 7, est représentée une simulation de la température maximale T (normalisée) d'une couche de GaN lorsque celle-ci est soumise à différentes puissances (en abscisses), cette couche utile en GaN ayant été formée sur une structure composite 40 comprenant une plaque support 20 en SiC polycristallin et une couche monocristalline Si<111> d'une épaisseur de 2 $\mu$m. Ce graphe est une comparaison entre le cas où cette structure composite 40 comprend une couche isolante 13 en $SiO_2$ de 1 $\mu$m (courbe 4) et le cas où elle ne comprend pas une telle couche isolante 13 (courbe 5).

Les résultats de cette simulation montrent qu'une couche isolante 13 peu épaisse (inférieure à 1 $\mu$m) ne modifie pas significativement les propriétés de dissipation thermique de la structure composite 40 (de l'ordre de 0 % pour une puissance de 5 W/mm à 5 % pour une puissance de 15 W/mm).

La Demanderesse a ainsi démontré qu'une structure composite 40 pouvait très bien contenir une couche isolante 13 sans que ses propriétés de dissipation thermique en soient sensiblement atténuées.

**Revendications**

1. Structure composite (40) pour des applications en optique, optoélectronique ou électronique, comprenant une plaque support (20) et une couche (11) en matériau choisi parmi les matériaux monocristallins et une couche en matériau diélectrique (13), **caractérisé en ce que** les matériaux composant la plaque support (20), la couche en matériau monocristallin (11) et la couche diélectrique (13) sont choisis, et l'épaisseur de chaque couche est ajustée, de sorte que l'impédance thermique de la structure composite (40) soit inférieure ou égale à environ 1,3 fois l'impédance thermique d'une plaque de SiC massif monocristallin ayant les mêmes dimensions que la structure composite entre la température ambiante et 600°K.

2. Structure composite (40) selon la revendication précédente, **caractérisée en ce que** la plaque support (20) est en un matériau ayant une impédance thermique sensiblement plus faible que l'impédance thermique du silicium massif monocristallin.

3. Structure composite (40) selon la revendication précédente, **caractérisé en ce que** le matériau est en outre choisi pour avoir une résistivité électrique supérieure à environ 10[4]ohms.cm.

4. Structure composite (40) selon l'une des deux revendications précédentes, **caractérisée en ce que** la plaque support (20) est en SiC massif polycristallin, en AlN massif polycristallin ou en céramique.

5. Structure composite (40) selon l'une des revendications précédentes, **caractérisée en ce que** ledit ajustement d'épaisseur de couche ait été réalisé de sorte que l'épaisseur de la couche en matériau diélectrique (13) soit inférieure ou égale à une épaisseur plafond et que l'épaisseur de la couche en matériau monocristallin (11) soit supérieure ou égale à une épaisseur seuil.

6. Structure composite (40) selon l'une des revendications précédentes, **caractérisée en ce que** le matériau diélectrique est du $SiO_2$ et/ou du $Si_3N_4$ et/ou du $Si_xO_yN_z$.

7. Structure composite (40) selon les deux revendications précédentes, **caractérisée en ce que** l'épaisseur de la couche en matériau diélectrique (13) est choisie inférieure à environ 0,20 micromètre, et **en ce que** l'épaisseur de la couche en matériau monocristallin (11) est choisi e en fonction de cette épaisseur de couche en matériau diélectrique (13) de sorte que la structure composite (40) soit inférieure ou égale à environ 1,3 fois l'impédance thermique d'une plaque en SiC massif monocristallin ayant les mêmes dimensions que la structure composite entre la température ambiante et 600°K.

8. Structure composite (40) selon la revendication précédente, **caractérisée en ce que** l'épaisseur de la couche en matériau diélectrique (13) est en outre choisie supérieure à environ 0,02 micromètre.

9. Structure composite (40) selon l'une des revendications 1 à 7, **caractérisée en ce que** le matériau de la couche en matériau monocristallin (11) est choisi parmi les matériaux semiconducteurs de sorte à pouvoir y former des composants électroniques.

10. Structure composite (40) selon la revendication précédente, **caractérisée en ce que** la couche (11) en matériau semiconducteur comprend au moins un composant électronique de type CMOS.

11. Structure composite (40) selon l'une des deux revendications précédentes, **caractérisée en ce que** le matériau monocristallin est du Si, du SiGe, ou du Ge.

12. Structure composite (40) selon l'une des revendications 1 à 8, **caractérisée en ce que** le matériau monocristallin de la couche en matériau monocristallin (11) est choisi pour réussir une croissance d'un semiconducteur de nitrure monocristallin, la structure composite (40) servant ainsi de substrat à la croissance de ce semiconducteur de nitrure, et pour avoir une résistivité électrique supérieure à environ $10^4$ ohms.cm.

13. Structure composite (40) selon la revendication précédente, **caractérisée en ce que** ledit matériau monocristallin est du SiC, du Si<111 >, ou du GaN.

14. Structure composite (40) selon la revendication 7 ou 8 combinée avec la revendication 11 ou 13, **caractérisée en ce que** l'épaisseur de la couche en matériau monocristallin (11) est supérieure à une épaisseur seuil d'environ 0,06 micromètre.

15. Structure composite (40) selon la revendication précédente, **caractérisée en ce que** l'épaisseur de la couche en matériau monocristallin (11) est en outre choisie inférieure à environ 1 micromètre.

16. Structure composite (40) selon la revendication 1, **caractérisée en ce que** :

   - la plaque support (20) est en SiC polycristallin ;
   - la couche en matériau monocristallin (11) est en Si<111 > et a une épaisseur choisie entre environ 0,2 et environ 1,0 micromètre ; et
   - la couche en matériau diélectrique (13) est en $SiO_2$ et a une épaisseur d'environ 0,20 micromètre.

17. Structure composite (40) selon la revendication 1, **caractérisée en ce que** :

   - la plaque support (20) est en SiC polycristallin ;
   - la couche en matériau monocristallin (11) est en Si<111 > et a une épaisseur choisie entre environ 0,06 et environ 1,00 micromètre ; et
   - la couche en matériau diélectrique (13) est en $SiO_2$ et a une épaisseur d'environ 0,05 micromètre.

18. Structure hybride (50) destinée à servir de substrat à une croissance cristalline d'un semiconducteur de nitrure, **caractérisée en ce qu'**elle comprend une structure composite (40) selon l'une des revendications précédentes et une structure supérieure (12) monocristalline sur la couche en matériau monocristallin (11), le(s) matériau(x) constituant la structure supérieure (12) étant adapté(s) pour améliorer la qualité de la couche du semiconducteur de nitrure à former sur la structure hybride (50) par rapport au cas où la couche de semiconducteur de nitrure aurait été formée directement sur la couche en matériau monocristallin (11).

19. Structure hybride (50) selon la revendication précédente, **caractérisée en ce que** la couche en matériau monocristallin (11) est en SiC, en Si <111 >, ou en GaN , et **en ce que** la structure supérieure (12) comprend une couche en un matériau choisi parmi les alliages suivants : $Al_xIn_yGa_{(1-x-y)}N$, $In_yGa_{(1-y)}N$, $Al_xGa_{(1-x)}N$ avec $0 \leq x \leq 1$ et $0 \leq y \leq 1$.

20. Structure hybride (50) selon la revendication précédente, **caractérisée en ce qu'**au moins un des éléments de l'alliage choisi parmi les alliages suivants : $Al_xIn_yGa_{(1-x-y)}N$, $In_yGa_{(1-y)}N$, $Al_xGa_{(1-x)}N$ avec $0 \leq x \leq 1$ et $0 \leq y \leq 1$, a sa concentration variant graduellement en épaisseur.

21. Structure pour application dans les HEMTs comprenant une structure composite (40) selon l'une des revendications 12 à 17 ou une structure hybride (50) selon l'une des revendications 18 à 20, et une couche en GaN monocristallin sus-épitaxiée.

**22.** Procédé de réalisation d'une structure composite (40), à partir d'une plaque donneuse (30) comportant un matériau monocristallin, **caractérisé en ce qu'**il comprend les étapes suivantes :

(a) collage d'une plaque support (20) à la plaque donneuse (30) ;
(b) réduction de la plaque donneuse (30) de sorte à ne laisser sur la plaque support (20), qu'une structure reportée (36) incluant ledit matériau monocristallin sous forme de couche et dont la nature et l'épaisseur soient telles que la structure composite (40) ainsi formée ait une impédance thermique inférieure ou égale à environ 1,3 fois l'impédance thermique d'une plaque de SiC massif monocristallin ayant les mêmes dimensions que la structure composite entre la température ambiante et 600°K.

**23.** Procédé de réalisation d'une structure composite (40) selon la revendication 22, **caractérisé en ce qu'**il comprend en outre un choix d'un matériau massif pour la plaque support (20) qui a une impédance thermique sensiblement plus faible que l'impédance thermique du silicium massif monocristallin entre la température ambiante et 600°K.

**24.** Procédé de réalisation d'une structure composite (40) selon la revendication précédente, **caractérisé en ce que** la plaque support (20) est choisie en SiC massif polycristallin, e n AIN massif polycristallin ou en céramique.

**25.** Procédé de réalisation d'une structure composite (40) selon l'une des revendications 22 à 24, **caractérisé en ce que** l'étape (a) comprend la formation d'une couche de collage (13) en matériau diélectrique entre la plaque support (20) et la plaque donneuse (30), de sorte que l'épaisseur de cette couche de collage (13) soit inférieure à une épaisseur plafond au-delà de laquelle l'impédance thermique de la structure composite (40) n'est pas inférieure ou égale à environ 1,3 fois l'impédance thermique d'une plaque de SiC massif monocristallin ayant les mêmes dimensions que la structure composite (40) entre la température ambiante et 600°K.

**26.** Procédé de réalisation d'une structure composite (40) selon l'une des revendications 22 à 25, **caractérisé en ce qu'**il comprend en outre, avant l'étape (a), une étape d'implantation d'espèces atomiques sous la surface de collage de la plaque donneuse (30) à une profondeur déterminée pour y former une zone de fragilisation (35), et **en ce que** l'étape (b) comprend un apport d'énergie de sorte à détacher la structure reportée (36) de la plaque donneuse au niveau de la zone de fragilisation (35), la profondeur de l'implantation étant déterminée pour que la zone de fragilisation (35) et la surface de collage définissent entre elles la structure reportée (36).

**27.** Procédé de réalisation d'une structure composite (40) selon l'une des revendications 22 à 25, **caractérisé en ce que** l'étape (b) est mise en oeuvre par des moyens mécaniques et/ou chimiques aptes à amincir l'épaisseur de la plaque donneuse (30).

**28.** Procédé de réalisation d'une structure composite (40) selon l'une des revendications 22 à 27, **caractérisé en ce que** la plaque donneuse (30) est en matériau massif monocristallin, et **en ce que** l'étape (b) est mise en oeuvre de sorte à ne conserver de la plaque donneuse (30) qu'une couche (11) dont l'épaisseur est choisie pour que la structure composite (40) formée ait une impédance thermique inférieure ou égale à environ 1,3 fois l'impédance thermique d'une plaque de SiC massif monocristallin ayant les mêmes dimensions que la structure composite (40) entre la température ambiante et 600°K.

**29.** Procédé de réalisation d'une structure composite (40) selon la revendication précédente, **caractérisé en ce que** la plaque donneuse (30) est en Si massif monocristallin ou en Ge massif monocristallin.

**30.** Procédé de réalisation d'une structure composite (40) selon la revendication 28, **caractérisé en ce que** la plaque donneuse (30) est en SiC massif monocristallin.

**31.** Procédé de réalisation d'une structure composite (40) selon l'une des revendications 22 à 27, **caractérisé en ce que** la plaque donneuse (30) comprend initialement ladite couche en matériau monocristallin (11) et un substrat de croissance adapté, et **en ce que** le procédé comprend en outre, avant l'étape (a), une étape de formation de la plaque donneuse (30) incluant la croissance cristalline de la couche en matériau monocristallin (11) sur le substrat de croissance adapté.

**32.** Procédé de réalisation d'une structure composite (40) selon la revendication précédente, **caractérisé en ce que** le substrat de croissance comprend du Si massif ou du Ge massif ainsi qu'une couche tampon en SiGe, et **en ce que** la couche en matériau monocristallin (11) est en Si ou en SiGe.

**33.** Procédé de réalisation d'une structure composite (40) selon la revendication 31, **caractérisé en ce que** le substrat de croissance comprend du saphir (Al$_2$O$_3$) massif, du SiC monocristallin massif, du ZnO massif ou du Si<111 > massif, et la couche en matériau monocristallin (11) est en SiC, en Si<111>, en GaN, en AlN, en InN, en $Al_xIn_yGa_{(1-x-y)}$, en $In_yGa_{(1-y)}N$, ou en $Al_xGa_{1-x}N$ avec $0 \leq x \leq 1$ et $0 \leq y \leq 1$.

**34.** Procédé de réalisation d'une structure hybride (50) comprenant la réalisation d'une structure composite (40) conformément au procédé de réalisation d'une structure composite (40) selon l'une des revendications 22 à 33, **caractérisé en ce qu'**il comprend en outre la croissance cristalline d'une structure supérieure monocristalline (12) sur la couche en matériau monocristallin (11) de sorte que la structure supérieure (12) ait une configuration et qu'elle soit constituée par des matériaux permettant d'améliorer la qualité d'une couche en semiconducteur de nitrure à former par rapport au cas où cette formation de semiconducteur de nitrure serait faite directement sur la couche en matériau monocristallin (11).

**35.** Procédé de réalisation d'une structure hybride (50) selon la revendication précédente, **caractérisée en ce que** la structure supérieure (12) comprend une couche choisie parmi les alliages suivants : $Al_xIn_yGa_{(1-x-y)}N$, $In_yGa_{(1-y)}N$, $Al_xGa_{(1-x)}N$ avec $0 \leq x \leq 1$ et $0 \leq y \leq 1$.

**36.** Procédé de réalisation d'une structure hybride (50) selon l'une des deux revendications précédentes, **caractérisée en ce que** la structure supérieure (12) comprend une couche choisie parmi les alliages suivants : $Al_xIn_yGa_{(1-x-y)}N$, $In_yGa_{(1-y)}N$, $Al_xGa_{(1-x)}N$ avec $0 \leq x \leq 1$ et $0 \leq y \leq 1$, au moins un des éléments de l'alliage choisi ayant sa concentration variant graduellement dans l'épaisseur.

FIG.1

FIG.2

FIG.3

FIG.4

FIG.5a

FIG.5b

FIG.5c

FIG.5d

FIG.5e

## FIG.6

## FIG.7

**EP 1 653 504 A1**

**Office européen des brevets**

**RAPPORT DE RECHERCHE EUROPEENNE**

Numéro de la demande

EP 05 10 9803

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2004/178448 A1 (RAYSSAC OLIVIER ET AL) 16 septembre 2004 (2004-09-16) * le document en entier * ----- | 1-36 | H01L21/762 |
| X | US 2003/025198 A1 (CHRYSLER GREGORY M ET AL) 6 février 2003 (2003-02-06) * figures 1a-1c * ----- | 22 | |
| A | US 2003/219959 A1 (GHYSELEN BRUNO ET AL) 27 novembre 2003 (2003-11-27)   * tableau 1 * ----- | 7,8, 13-17, 30,33, 35,36 | |
| A | US 2003/064535 A1 (KUB FRANCIS J ET AL) 3 avril 2003 (2003-04-03)   * le document en entier * ----- | 12, 18-21, 33-36 | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| Munich | 1 février 2006 | Kuchenbecker, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 10 9803

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-02-2006

| Document brevet cité au rapport de recherche | Date de publication | Membre(s) de la famille de brevet(s) | Date de publication |
|---|---|---|---|
| US 2004178448    A1 | 16-09-2004 | AUCUN | |
| US 2003025198    A1 | 06-02-2003 | CN        1539166 A<br>EP        1412980 A1<br>JP     2004537860 T<br>WO       03012864 A1<br>US     2004157386 A1 | 20-10-2004<br>28-04-2004<br>16-12-2004<br>13-02-2003<br>12-08-2004 |
| US 2003219959    A1 | 27-11-2003 | AU        2203702 A<br>CN        1541405 A<br>EP        1338030 A2<br>FR        2817395 A1<br>WO        0243124 A2<br>JP     2004519093 T<br>TW         554452 B | 03-06-2002<br>27-10-2004<br>27-08-2003<br>31-05-2002<br>30-05-2002<br>24-06-2004<br>21-09-2003 |
| US 2003064535    A1 | 03-04-2003 | AUCUN | |

EPO FORM P0460

Pour tout renseignement concernant cette annexe : voir Journal Officiel de l'Office européen des brevets, No.12/82